**Europäisches Patentamt**

**European Patent Office**

**Office européen des brevets**

(11) Veröffentlichungsnummer: **0 294 572**
**A1**

(12) **EUROPÄISCHE PATENTANMELDUNG**

(21) Anmeldenummer: 88106467.9

(22) Anmeldetag: 22.04.88

(51) Int. Cl.⁴: **C23C 16/52 , C23C 16/02 , H01J 37/32**

(30) Priorität: 12.06.87 DE 3719616

(43) Veröffentlichungstag der Anmeldung:
14.12.88 Patentblatt 88/50

(84) Benannte Vertragsstaaten:
AT BE CH DE FR GB IT LI NL

(71) Anmelder: **LEYBOLD AKTIENGESELLSCHAFT**
**Wilhelm-Rohn-Strasse 25**
**D-6450 Hanau 1(DE)**

(72) Erfinder: **Hubert, Peter**
**Elzestrasse 12**
**D-8755 Alzenau(DE)**
Erfinder: **Kussel, Barbara, Dr.**
**Maistrasse 14**
**D-6054 Rodgau 1(DE)**
Erfinder: **Wirz, Peter, Dr.**
**Klosterstrasse 5**
**D-6296 Waldernbach(DE)**

(54) Verfahren und Vorrichtung zur Beschichtung eines Substrats.

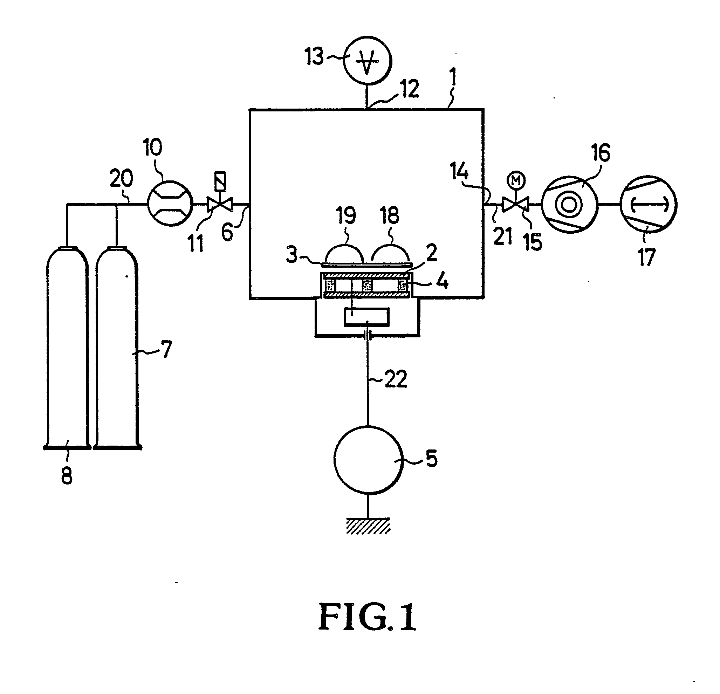

(57) Bei einer Vorrichtung (Fig. 1) zum Beschichten eines Substrats (3) mit einer organischen Schicht durch Einbringen des Substrats (3) in eine eine gasförmige Kohlenwasserstoffverbindung enthaltende Beschichtungskammer (1), in der mit Hilfe einer Magnete (4) aufweisenden Kathodenanordnung (2, 4) die Kohlenwasserstoffverbindung zersetzbar ist, wobei ein sich im Bereich des Substrats (3) bildendes Plasma (18, 19) durch Anlegen einer hochfrequenten Spannung an die Kathodenanordnung (2) anregbar und das Substrat (3) unmittelbar vor der Kathode (2) gehalten ist, ist der Druck in der Beschichtungskammer (1) und die Zufuhr der elektrischen Energie vom Generator (5) zur Kathode (2) zum Zwecke einer sich während des Schichtaufbaus verändernden Schichtqualität variierbar. Zu diesem Zweck sind in die Gaszufuhrleitung (20) und in die Pumpen-Saugleistung (21) elektromotorisch antreibbare Absperrorgane (11, 15) eingeschaltet, die über ein Zeitschaltwerk oder eine Steuervorrichtung das mit einer Vakuummeßzelle (13) verbunden ist, angesteuert werden.

FIG.1

## Verfahren und Vorrichtung zur Beschichtung eines Substrats

Die Erfindung betrifft ein Verfahren und eine Vorrichtung zur Beschichtung eines Substrats mit einer organischen Schicht durch Einbringen des Substrats in eine eine gasförmige Kohlenwasserstoffverbindung enthaltende Beschichtungskammer, in der mit Hilfe einer Magnete aufweisenden Kathodenanordnung die Kohlenwasserstoffverbindung zersetzbar ist, wobei ein sich im Bereich des Substrats bildendes Plasma durch Anlegen einer hochfrequenten Spannung an die Kathodenanordnung anregbar und das Substrat unmittelbar von der Kathode gehalten ist.

Es ist bereist bekannt, auf dünnwandige Substrate, beispielsweise Daten- oder Tonträger, eine dünnwandige Schicht mit Hilfe einer ionisierten Gasatmosphäre bzw. durch plasmaunterstützte CVD anzubringen, wobei zur Anregung des Plasmas Hochfrequenz verwendet und mit Hilfe eines Magnetsystems eine Konzentration der chemischen Reaktion vor der Kathode bewirkt wird. Da die Speicherdichte magnetischer Datenträger sehr stark durch die Schichtdicke der magnetisierbaren Schicht und dem Abstand des Magnetkopfes von dieser Schicht bestimmt wird, werden sehr dünne Schichten und besonders kleine Kopfabstände angestrebt. Erfahrungsgemäß erhöht sich aber auch dadurch die Gefahr der Beschädigung der Schicht durch den Kontakt des Kopfes mit der Schicht, verursacht beispielsweise durch Vibration oder durch Staubteilchen. Zum anderen muß aber auch die Abnutzung des Magnetkopfes, insbesondere bei Start-Stop-Betrieb so gering wie möglich gehalten werden. Da es mit dem vorbekannten Beschichtungsverfahren nur möglich ist, eine einzige Schicht mit einem sehr homogenen Aufbau herzustellen, muß der Hersteller von Datenträgern Kompromisse hinsichtlich der Schichtqualität eingehen.

Der vorliegenden Erfindung liegt die Aufgabe zugrunde, ein Verfahren und eine Vorrichtung zu - schaffen, die geeignet sind, einerseits eine sehr dünne und den Magnetkopf schonende und andererseits eine gegen Beschädigungen vergleichsweise unempfindliche Schicht herzustellen.

Erfindungsgemäß wird dies durch ein Verfahren ermöglicht, bei dem der Druck in der Beschichtungskammer und die Zufuhr der elektrischen Energie vom Generator zur Kathode zum Zwecke einer sich während des Schichtaufbaus verändernden Schichtqualität definiert variiert werden, wobei durch Erhöhung des Drucks in der Beschichtungskammer oder durch Verminderung der Energiezufuhr die Härte, der Reibungskoeffizient und der Brechungsindex der Schicht einen vorgegebenen Gradienten erhalten.

Bei einer für die Durchführung dieses Verfahrens geeigneten Vorrichtung sind in die vom Gas-Vorratsbehälter zur Beschichtungskammer führenden Gas-Zuleitung und in die die Vakuumpumpe mit der Beschichtungskammer verbundene Pumpen-Saugleitung Absperrorgane eingeschaltet, über die der in der Beschichtungskammer herrschende Druck und die Durchflußmenge des Gases regulierbar sind.

Vorzugsweise sind dazu die in die Gas-Zuleitung und in die Pumpen-Saugleitung eingeschalteten Absperrorgane elektromotorisch, hydraulisch oder pneumatisch in Abhängigkeit eines Zeitschaltwerks verstellbar.

Zweckmäßigerweise ist der an die elektrische Zuleitung der Kathode angeschlossene Generator in seiner Leistung über ein elektrisch, hydraulisch oder pneumatisch betätigbares Stellglied in Abhängigkeit eines Zeitschaltwerks oder einer Steuervorrichtung verstellbar.

Um eine Schicht mit einem Härtegradienten zu erzeugen, bei dem auf eine zunächst härtere Schutzschicht eine weichere Oberflächenschicht folgt, wirken das Zeitschaltwerk und/oder die Steuervorrichtung mit einer Vakuummeßzelle zusammen, die mit der Beschichtungskammer in Verbindung steht und die dem Druck in der Beschichtungskammer entsprechende Steuersignale erzeugt und an das Zeitschaltwerk oder die Steuervorrichtung leitet.

Mit Vorteil wirken das Zeitschaltwerk und/oder die Steuervorrichtung mit einem Durchfluß-Meßgerät zusammen, das in die Gas-Zuleitung zwischen dem Gasbehälter und dem Absperrorgan eingeschaltet ist und das dem Gaszufluß zur Beschichtungskammer entsprechende Signale erzeugt und an das Zeitschaltwerk oder die Steuervorrichtung gibt.

Bei einer bevorzugten Ausführungsform sind die ein Magnetfeld vor der Kathode erzeugenden Magnete mit ihrer Halterung am Kathodenträger beweglich angeordnet und mit Hilfe besonderer Motoren drehbar, wodurch eine besonders gleichmäßige Schichtdicke erzielt wird.

Die Erfindung läßt die verschiedensten Ausführungsmöglichkeiten zu; eine davon ist in der anhängenden Zeichnung näher dargestellt und zwar zeigen

Fig. 1 eine Vorrichtung zum Beschichten von Datenträgern mit einer organischen Schutzschicht durch Zersetzen einer gasförmigen Kohlenwasserstoffverbindung in schematischer Darstellung,

Fig. 2 eine Kathode für eine Vorrichtung nach Fig. 1 rein schematisch und in vergrößerter Abbildung, wobei das sich im Betrieb bildende Plasma und die von dem Magneten erzeugten Feldlinien mit Hilfe punktierter Felder bzw. durch Pfeile angedeutet sind und

Fig. 3 bis 6 Diagramme zur Darstellung der mit dem Verfahren beispielsweise erzielbaren physikalischen Werte von Schichten.

Die Vorrichtung besteht im wesentlichen aus der Beschichtungskammer 1 mit der in ihr angeordneten Kathode 2, dem oberhalb der Kathode 2 angeordneten Substrat 3, den zur Kathode 2 gehörenden Magneten 4, der elektrischen Energiequelle 5, dem Anschluß 6 für die Gasflaschen 7, 8, dem in die Gas-Zufuhrleitung 20 eingeschalteten Durchfluß-Meßgerät 10 mit einem magnetisch angetriebenen Absperrorgan 11, die über den Anschluß 12 an die Beschichtungskammer 1 angeschlossene Vakuum-Meßzelle 13 und einem mit der Beschichtungskammer 1 über einen Anschluß 14 verbundenen elektromotorisch angetriebenen Absperrorgan 15 für die Turbovakuumpumpe 16 und die dieser nachgeschalteten Wälzkolbenvakuumpumpe 17.

Nach dem Einschleusen des Substrats 3 in die evakuierte Beschichtungskammer 1 bilden sich auf der der Kathode 2 abgekehrten Seite des Substrats 3 Plasma-Schläuche 18, 19 durch Zersetzen des über den Anschluß 6 eingeleiteten Monomers (z.B. Acetylen-Gas) aus, wobei zur Anregung des Plasmas Hochfrequenz (z.B. 13,56 MHz) an der Kathode 2 anliegt, die von der Energiequelle 5 bzw. dem Generator erzeugt wird. Gegebenenfalls kann dem Acetylen-Gas noch ein Inertgas, z.B. Argon, beigemischt werden. Durch Einstellen der Verfahrensparameter können die Eigenschaften der Schicht verändert werden, speziell können die mechanischen Eigenschaften wie z.B. Härte und Reibungskoeffizient kontinuierlich im Verlauf der Beschichtung variiert werden, sodaß ein Härtegradient entsteht der Gestalt, daß auf eine zunächst härtere Schutzschicht eine weichere Oberflächenschicht folgt. Mit diesem Gradienten wird erreicht, daß bei optimaler Schutzwirkung für das Substrat, beispielsweise einen Datenträger, die Abnutzung eines mit dem Datenträger zusammenwirkenden Magnetkopfes möglichst gering bleibt.

Eine Änderung der eingekoppelten Leistung bewirkt eine Veränderung der Energie der auf das Substrat 3 auftreffenden Teilchen und damit eine Strukturveränderung. Es können also Gradienten innerhalb der Schicht hergestellt werden, indem man während der Beschichtung von einem Arbeitspunkt zum nächsten übergeht. Ähnlich wirkt eine Veränderung des Druckes in der Beschichtungskammer 1 während der Beschichtung.

Zweckmäßigerweise wird der Datenträger bzw. das Substrat 3 zunächst mit einer relativ harten Schutzschicht versehen, und im Verlaufe dieser Beschichtung werden die Leistung und der Druck verändert derart, daß die Oberfläche eine Schicht erhält, die weicher ist und damit gute Gleiteigenschaften aufweist. Auf diese Weise wird in einem einzigen Beschichtungsvorgang eine zum Schutz der magnetisierbaren Schicht möglichst harte Schicht mit einer für den Start-Stop-Betrieb besonders günstigen weicheren Schicht mit niedrigem Reibungskoeffizienten kombiniert.

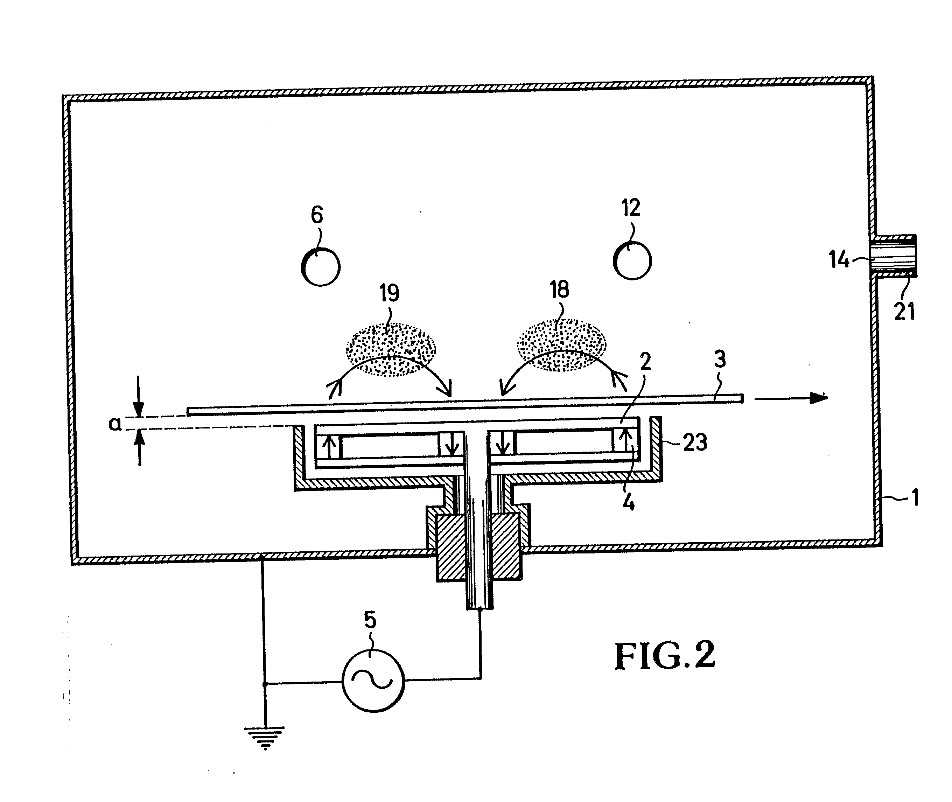

Wie Fig. 2 am Beispiel einer Ausführungsvariante für eine Kathodenanordnung zeigt, ist der Dunkelraum-Abstand a zwischen dem Substrat 3 und der Kathode 2 sehr eng bemessen, sodaß sichergestellt ist, daß sich im Raum zwischen dem Substrat 3 und der Kathode 2 keine Plasmawolke ausbildet, d.h. der bei den gewählten Prozeßparametern (z.B. Druck und Leistung) sich einstellende Dunkelraumabstand darf nicht überschritten werden.

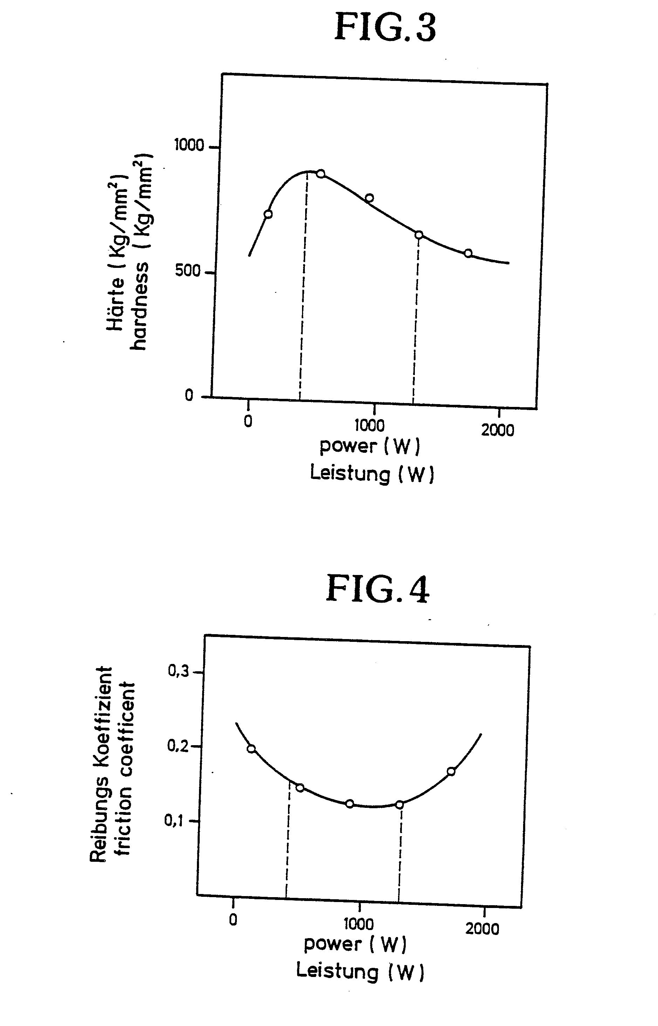

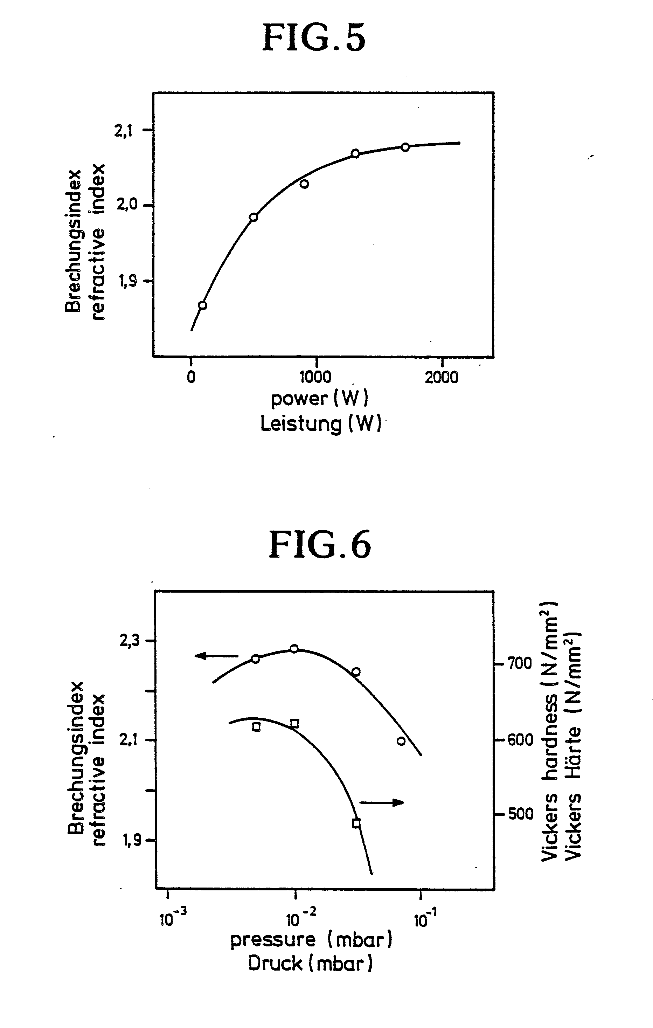

In Fig. 3 ist in einem Diagramm die Abhängigkeit der Härte der Schicht von der während des Beschichtungsvorgangs anliegenden elektrischen Spannung aufgezeigt. Es ist erkennbar, daß ein Härte-Maximum bei einer Leistung von etwa 400 W erzielbar ist. Fig. 4 zeigt, daß sich ein minimaler Reibungskoeffizient bei etwa 1.000 W Leistung einstellt und daß bei noch geringerer oder noch höherer Leistung der Reibungskoeffizient einem Maximum zustrebt. Wie Fig. 5 zeigt, ist auch der Brechungsindex von der anliegenden elektrischen Leistung abhängig, und zwar nimmt er zu, je höher die Leistung ist, bis er bei etwa 2.000 W Leistung einen maximalen Wert erreicht. Im Diagramm nach Fig. 6 ist aufgezeigt, daß der Brechungsindex und Schichthärte auch vom Druck abhängen, der während des Beschichtungsvorgangs in der Beschichtungskammer 1 herrscht. Beide Werte erreichen ein Maximum bei einem Druck von etwa $10^{-2}$ mbar.

## Auflistung der Einzelteile

  1 Beschichtungskammer
  2 Kathode
  3 Substrat
  4 Magnet
  5 elektrische Energiequelle, Generator
  6 Anschluß
  7 Gasflasche, Azethylenflasche
  8 Gasflasche, Argonflasche
  10 Durchfluß-Meßgerät
  11 magnetisch angetriebenes Absperrorgan
  12 Anschluß
  13 Vakuum-Meßzelle
  14 Anschluß
  15 Absperrorgan mit elektromotorischem Antrieb
  16 Turbovakuumpumpe

17 Wälzkobenvakuumpumpe
18 Plasma-Schlauch
19 Plasma-Schlauch
20 Gas-Zuleitung
21 Pumpen-Saugleitung
22 elektrische Anschlußleitung
23 Anode

## Ansprüche

1. Verfahren zur Beschichtung eines Substrats (3) mit einer organischen Schicht durch Einbringen des Substrats (3) in eine eine gasförmige Kohlenwasserstoffverbindung enthaltende evakuierbare Beschichtungskammer (1), in der mit Hilfe einer Magnete (4) aufweisenden Kathodenanordnung (2, 4) die Kohlenwasserstoffverbindung zersetzbar ist, wobei im Bereich des Substrats (3) durch Anlegen einer hochfrequenten Spannung an die Kathodenanordnung (2) ein Plasma (18, 19) erzeugbar ist und wobei das Substrat (3) unmittelbar vor der Kathode gehalten ist, dadurch gekennzeichnet, daß der Druck in der Beschichtungskammer (1) und die Zufuhr der elektrischen Energie zur Kathode (2) zum Zwecke einer sich während des Schichtaufbaus verändernden Schichtqualität definiert variiert werden, wobei durch Erhöhung des Drucks in der Beschichtungskammer (1) oder durch Verminderung der Energiezufuhr die Härte, der Reibungskoeffizient und der Brechungsindex der Schicht einen vorgegebenen Gradienten erhalten.

2. Vorrichtung zur Durchführung des Verfahrens nach Anspruch 1, dadurch gekennzeichnet, daß in die vom Gas-Vorratsbehälter (7, 8) zur Beschichtungskammer (1) führende Gas-Zuleitung (20) und in die die Vakuumpumpe (16, 17) mit der Beschichtungskammer (1) verbindende Pumpen-Saugleitung (21) Absperrorgane (11 bzw. 15) eingeschaltet sind, über die der in der Beschichtungskammer (1) herrschende Druck regulierbar ist.

3. Vorrichtung nach Anspruch 2, dadurch gekennzeichnet, daß die in die Gas-Zuleitung (20) und in die Pumpen-Saugleitung (21) eingeschalteten Absperrorgane (11 bzw. 15) elektromotorisch, hydraulisch oder pneumatisch in Abhängigkeit eines Zeitschaltwerks verstellbar sind.

4. Vorrichtung nach den vorherigen Ansprüchen, dadurch gekennzeichnet, daß der an die elektrische Zuleitung (22) der Kathode (2) angeschlossene Generator (5) in seiner Leistung über ein elektrisch, hydraulisch oder pneumatisch betätigbares Stellglied in Abhängigkeit eines Zeitschaltwerks oder einer Steuervorrichtung verstellbar ist.

5. Vorrichtung nach einem oder mehreren der Ansprüche 2 bis 4, dadurch gekennzeichnet, daß das Zeitschaltwerk und/oder die Steuervorrichtung mit einer Vakuummeßzelle (13) zusammenwirkt, die mit der Beschichtungskammer in Verbindung steht, und die dem Druck in der Beschichtungskammer (1) entsprechende Steuersignale erzeugt und an das Zeitschaltwerk bzw. die Steuervorrichtung leitet.

6. Vorrichtung nach einem oder mehreren der Ansprüche 2 bis 5, dadurch gekennzeichnet, daß das Zeitschaltwerk und/oder die Steuervorrichtung mit einem Durchfluß-Meßgerät (10) zusammenwirkt, das in die Gas-Zuleitung (20) zwischen dem Gasbehälter (7, 8) und dem Absperrorgan (11) eingeschaltet ist, und das dem Gaszufluß zur Beschichtungskammer (1) entsprechende Signale erzeugt.

7. Vorrichtung nach einem oder mehreren der Ansprüche 2 bis 6, dadurch gekennzeichnet, daß die ein Magnetfeld vor der Kathode erzeugenden Magnete (4) mit ihrer Halterung am Kathodenträger beweglich angeordnet und von besonderen Motoren drehbar sind.

FIG. 1

FIG.2

# FIG.3

# FIG.4

# FIG.5

# FIG.6

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-3 202 709 (FRAUNHOFER-GESELLSCHAFT ZUR FÖRDERUNG DER ANGEWANDTEN FORSCHUNG) * Ansprüche 1,6,7,9,10; Seite 6, Zeilen 11-14; Seite 7, Zeilen 27-31; Seite 15, Zeilen 29-34; Figur 2 * --- | 1,2 | C 23 C  16/52 C 23 C  16/02 H 01 J  37/32 |
| A | EP-A-0 157 212 (AMERICAN CYANAMID CO.) * Seite 4, Zeilen 13-21; Seite 9, Zeilen 12-30; Figur 1 * --- | 1,2,4 | |
| A | EP-A-0 085 397 (TOSHIBA KIKAI K.K.) * Seite 6, Zeile 15 - Seite 8, Zeile 16; Anspruch 1; Figuren 7,8 * --- | 2,3,5,6 | |
| A | DE-A-3 521 318 (LEYBOLD-HERAEUS GmbH) * Seite 17, Zeilen 16-18; Figur 1 * ----- | 7 | |

RECHERCHIERTE SACHGEBIETE (Int. Cl.4)

C 23 C
H 01 J

Der vorliegende Recherchenbericht wurde für alle Patentansprüche erstellt

| Recherchenort | Abschlußdatum der Recherche | Prüfer |
|---|---|---|
| DEN HAAG | 15-09-1988 | JOFFREAU P.O. |